# EUROPEAN PATENT SPECIFICATION

(11) **EP 4 309 473 B1**
(45) Date of publication and mention of the grant of the patent: **23.04.2025**
(21) Application number: 22713700.7
(22) Date of filing: 18.03.2022
(51) Int. Cl.: H05K 5/06

(54) **A CASING AND A METHOD FOR ENCAPSULATION USING INJECTION MOULDING**
GEHÄUSE UND VERFAHREN ZUR VERKAPSELUNG DURCH SPRITZGIESSEN
BOÎTIER ET PROCÉDÉ D'ENCAPSULATION PAR MOULAGE PAR INJECTION

(30) Priority: 19.03.2021 FI 20215308
(43) Date of publication of application: 24.01.2024
(73) Proprietor: Efla Oy, 06150 Porvoo (FI)
(72) Inventor: SYRJÄNEN, Janne, 24100 Salo (FI); JUHOLA, Harri, 15140 Lahti (FI); MATTILA, Janne, 07140 Kråkö (FI)
(74) Representative: Papula Oy
(86) International application number: PCT/FI2022/050178
(87) International publication number: WO 2022/195175

(56) References cited:
- EP-A1- 0 777 407
- EP-A1- 2 136 612
- US-A1- 2004 075 989
- US-A1- 2006 261 452
- WENG D ET AL: "FUNDAMENTALS AND MATERIAL DEVELOPMENT FOR THERMOPLASTIC ELASTOMER (TPE) OVERMOLDING", JOURNAL OF INJECTION MOLDING TECHNOLOGY, SOCIETY OF PLASTICS ENGINEERS, BROOKFIELD, CT, US, vol. 4, no. 1, 1 March 2000 (2000-03-01), pages 22 - 28, XP000903999, ISSN: 1533-905X

## Description

### TECHNICAL FIELD

Various example embodiments generally relate to the field of manufacturing. In particular, some example embodiments relate to manufacturing of a casing and providing an improved casing configured for housing, for example, electronics.

### BACKGROUND

Electronics may be housed in various types of casings. The casings may be configured to protect delicate electronic components from dust, moisture, and impacts. Different devices may require a different degree of protection depending on the needed reliability and harshness of the operating environment. Properties of the casings may be limited in terms of cost, materials, and by their manufacturing process.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

Example embodiments provide an improved process for manufacturing a casing suitable for protection of electronics. The casing is seamed with injection moulding such that the casing is hermetically sealed. The casing and the moulding material used for injection moulding may comprise a same material, such as an elastomer, which may enhance protective properties of the casing.

According to a first aspect, a method for encapsulation comprising the features of the independent claim 1 is provided. The method comprises forming a casing by connecting at least a first casing component and a second casing component, wherein at least one of the first casing component or the second casing component is shaped to provide a sealing groove along a seam between the first casing component and the second casing component; and hermetically sealing the seam by filling the sealing groove by injection moulding. This enables, that a durable and impermeable seal may be provided for an encapsulation casing. The casing may be uniform such that it does not comprise any moving parts. By injection moulding the seam, also elastic materials may be used for manufacturing the casing. Further, a nontoxic material may be used for sealing the seam which improves safety at the manufacturing site as well as decreases environmental impact. The provided manufacturing method is simple yet enables manufacturing of casings with increased protective properties, for example, for encapsulation of electronics.

According to the invention, a cross-section of the sealing groove is determined based on dimensions of the casing such that the sealing groove is filled with a sufficient amount of material to melt the first and the second casing component together by the injection moulding. Hence, a required temperature for sealing the seam may be provided with a design of the sealing groove, wherein the injection molded material may not cool down too quickly.

According to an embodiment, in addition or alternatively, a cross-section of the sealing groove is substantially semi-circular. This provides good mould geometry for the injection moulding.

According to an embodiment, in addition or alternatively, the first casing component, the second casing component and the injection moulding comprise a same material. Hence, the injection moulded seam enables that the whole casing may be manufactured from a single material to provide a truly uniform component.

According to an embodiment, in addition or alternatively, at least one of the first or the second casing component comprises a different material than the injection moulding and wherein the materials have good adhesion to each other. Hence, casings manufactured from a plurality of materials may be hermetically sealed using the injection moulded seam. The injection moulded seam is suitable for a variety of casings and, hence, more durable and/or environmentally friendly encapsulation may be provided for products requiring different properties from the casing.

According to the invention, the first casing component and the second casing component comprise an elastomer. Hence, injection moulding the seam enables using elastomers for the casing which enables providing casings with improved resistance for impacts, temperature and chemicals.

According to an embodiment, in addition or alternatively, the method may comprise inserting an electronics assembly inside the casing before the sealing. This enables providing an encapsulated electronics assembly, wherein the injection moulding seamed casing provides improved protection of the electronics assembly.

According to an embodiment, in addition or alternatively, the method may comprise potting the electronics assembly before inserting the electronics assembly inside the casing, and wherein a size of the potted electronics assembly substantially corresponds to the size of the casing. Hence, protection of the electronics may be further increased with the potting matching the casing.

According to an embodiment, in addition or alternatively, the first casing component comprises wiring for the electronics assembly extending outside the casing, and wherein the first casing component and the wiring are made by injection moulding such that the wiring is hermetically sealed to the second casing component. Hence, the second casing component may function as an adapter enabling connecting the electronics assembly to an external device or system while the casing remains hermetically sealed.

According to a second aspect, a casing for encapsulation comprising the features of the independent claim 8 is provided. The casing comprises at least a first casing component connected to a second casing component to form the casing, wherein the first casing component and the second casing component are configured to form a sealing groove along a seam between the first casing component and the second casing component, and wherein the first casing component and the second casing component are hermetically sealed from the seam by filling the sealing groove by injection moulding. This enables, that a durable casing with an impermeable seal may be provided for encapsulation. The casing may be uniform such that it does not comprise any moving parts. Further, a nontoxic material may be used for moulding the seam which improves safety at the manufacturing site as well as decreases environmental impact. The casing may have improved protective properties, for example, for encapsulation of electronics.

According to an embodiment, the first casing component may comprise wiring configured to be coupled to an electronics assembly encapsulated by the casing and extending outside the casing, and wherein the wiring is hermetically sealed with the first casing component by injection moulding.

According to an embodiment, in addition or alternatively, the casing may encapsulate an electronics assembly.

Many of the attendant features will be more readily appreciated as they become better understood by reference to the following detailed description considered in connection with the accompanying drawings.

### BRIEF DESCRIPTION OF THE DRAWINGS

The accompanying drawings, which are included to provide a further understanding of the example embodiments and constitute a part of this specification, illustrate example embodiments and together with the description help to explain the example embodiments. In the drawings:
**Figure 1** illustrates an example of a first casing component of a casing, according to an example embodiment;
**Figure 2** illustrates an example of a second casing component of a casing, according to an example embodiment;
**Figure 3** illustrates an example of a first casing component of a casing coupled to a printed circuit board, according to an example embodiment;
**Figure 4** illustrates an example of a casing with a sealing groove for injection moulding formed by coupling a first casing component and a second casing component, according to an example embodiment;
**Figure 5** illustrates an example of a casing with a sealing groove for injection moulding formed by coupling a first casing component and a second casing component depicted from above, according to an example embodiment;
**Figure 6** illustrates an example of a casing formed by coupling a first casing component and a second casing component and sealed with injection moulding, according to an example embodiment;
**Figure 7** illustrates an example of a casing formed by coupling a first casing component and a second casing component and sealed with injection moulding depicted from above, according to an example embodiment;
**Figure 8** illustrates an example of method for manufacturing a casing for encapsulation, according to an example embodiment.

### DETAILED DESCRIPTION

Reference will now be made in detail to example embodiments, examples of which are illustrated in the accompanying drawings. The detailed description provided below in connection with the appended drawings is intended as a description of the present examples and is not intended to represent the only forms in which the present example may be constructed or utilized. The description sets forth the functions of the example and the sequence of operations for constructing and operating the example. However, the same or equivalent functions and sequences may be accomplished by different examples.

An assembly may be encapsulated by closing a casing of the assembly using, for example, screws or other mechanical fastening means, adhesive, ultrasonic welding, or hot plate welding. However, these alternatives are not ideal or suitable in many cases for sufficient protection. For example, screw fastening may not enable the casing to be hermetically sealed. Use of adhesives may be problematic due to environmental and health reasons because of their toxicity. In addition, adhesives or mechanical fastening means may not be reliable, as the screws may loosen or the adhesives embrittle when exposed to extreme temperatures, moisture, chemical fluids, and/or outdoor weathering. Furthermore, ultrasonic welding may not be suitable for all materials, such as elastomers, and heating plates may not be used for hot plate welding with inserts, e.g. items around which the moulding is made, which limits the choice of materials and achievable properties for the casing.

An objective of the disclosure is to provide a casing for encapsulation of electronics assembly and a method for manufacturing said casing. Advantageously, the casing is manufactured by sealing the casing with injection moulding. This enables, that the casing is manufactured from elastomers which improves protective properties of the casing. Use of elastomers may improve resistance of the casing for impacts compared to, for example, use of rigid plastics. Further, the elastomers enable use of the casing in a wider temperature range, compared to the rigid plastics which tend to embrittle in sub-zero conditions. In addition, the injection moulded seam provides a highly durable hermetical seal for the casing compared to other methods to close the seam, such as adhesives. Further, chemical resistance of the casing may be improved with the elastomers.

In general, injection moulding refers to a manufacturing process for producing parts by injecting molten material into a mould. Injection moulding may be performed with a host of materials mainly including metals (for which the process is called die-casting), glasses, elastomers, confections, and most commonly thermoplastic and thermosetting polymers. A casing may refer to a portable container for enclosing something, such as electronics or devices.

The disclosed manufacturing process of a casing enables providing an improved protective encapsulation for any component or system. In particular, reliable protection of assemblies comprising electronics may be provided. In an embodiment, the casing may be configured to enclose potted electronics to further improve protection of the electronics.

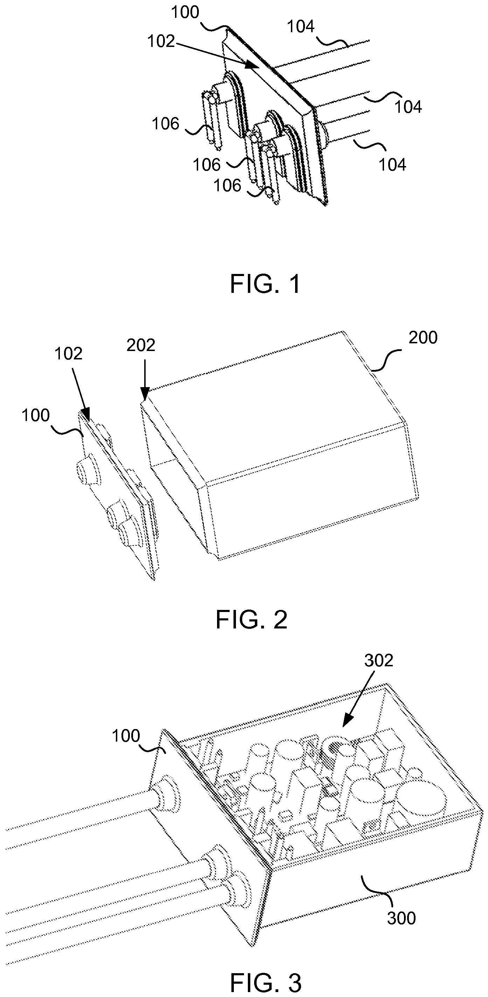

Figure 1 illustrates an example of a first casing component 100 of a casing, according to an example embodiment. The first casing component 100 is manufactured from a material comprising an elastomer. The first casing component 100 may be manufactured by injection moulding. The first casing component 100 may be shaped such that it is configured to form a sealing groove suitable for injection moulding when combined with a second casing component of the casing. The first casing component may comprise at least one wall comprising a groove 102 extending outward from at least one edge of the wall. The groove 102 may be at least part of the sealing groove. In an embodiment, the first casing component 100 may act as a lid for the second casing component. In an embodiment, the groove 102 may extend from each edge of the wall in the same direction, such as outward from one side of the wall acting as the lid. In an embodiment, instead of the flat and solid shape illustrated in figure 1, the first casing component 100 may be, for example, a hollow container open from at least one end, such as cuboid, cylindric or hemisphere component. The first casing component 100 may have also some other shape depending on requirements of the assembly to be protected by the casing or a system associated with the casing.

In an embodiment, the first casing component 100 may comprise one or more inlets for wiring. In addition, the first casing component 100 may comprise one or more wires 104. Hence, the first casing component 100 may function as an adapter configured to connect wires to an assembly housed by the casing. The first casing component 100 may be configured for joining parts or devices having different sizes and/or designs and enabling them to be fitted or to work together. The wires may be injection moulded to the first casing component 100, or the wires 104 may be injection moulded with the first casing component 100, in order to hermetically seal them with the first casing component 100. The wires 104 may extend from one side of the first casing component 100 to be coupled to a power supply. The wires 104 may comprise connectors 106 on an opposite side of the first casing component 100 than the power supply side. The connectors 106 may comprise, for example, end of the wires for soldering, flag connectors, terminals, or the like.

Figure 2 illustrates a second casing component 200 of a casing. The first casing component 100 as described in figure 1 may be configured to close the second casing component 200. The second casing component 200 may be, for example, a sleeve, i.e. a protective container with an opening on one side for insertion or removal of an item or assembly. The opening may be shaped such that a sealing groove for injection moulding is formed around or next to a seam of the first casing component 100 and the second casing component 200 when they are connected. For example, sides of the opening end may be concave or folded to form a groove 202. The groove 202 may be configured to form at least a part of the sealing groove when the second component 200 is coupled with the first component 100. The shape of the second casing component 200 illustrated in figure 2 is only one example, and the container may be wider or longer, and have a round or polyhedron shape. In an embodiment, the second casing component 200 may be open from more than one end, wherein each of the open ends are configured to form a groove for sealing with injection moulding. Hence, the second casing component may be hermetically sealable with injection moulding from each open end when connected with respective first casing components. In an embodiment, the second casing component 200 may be, for example, a hemisphere, a cylinder, a cube, a cuboid, flat, or have any shape suitable to be fitted with the first casing component 100 such that the sealing groove is formed by the seam of the first and the second casing component. The first and the second casing component may be configured to form at least partially hollow casing suitable for encapsulation of a system to be protected.

In an embodiment, a casing component, such as the first or the second casing component, may comprise at least one wall, wherein at least one edge of the at least one wall comprises a groove extending outward from the at least one edge. The casing component may comprise a plurality of walls and edges of the wall located at an opening of the casing component may be grooved. The groove is configured to form a sealing groove for injection moulding when coupled with a groove of another casing component to hermetically seal the casing components together from a seam between the grooves by the injection moulding. The casing component may be injection moulded using a mould comprising a plurality of mould parts configured to provide one or more moulding cavities when attached together for forming the casing component by the injection moulding. The mould may comprise an injection port in the mould for introducing mouldable plastics material into the cavity.

Position of the seam at the sealing groove may be selected such that the seam is covered when the sealing groove is filled during injection moulding. A material used for sealing the seam with the injection moulding may comprise any material with sufficient adhesion properties with the material(s) of the first and the second casing component. The material used for the injection moulding comprises an elastomer. According to the invention, each of the first casing component, the second casing component and the material used for injection moulding comprises an elastomer.

Figure 3 illustrates an example of a first casing component 100 of a casing coupled to a printed circuit board 302, according to an example embodiment. The first casing component 100 may correspond to the one described in figure 1. In an embodiment, the connectors 106 (illustrated in figure 1) may be coupled to an assembly to be protected by the casing, such as the printed circuit board (PCB) 302. In an embodiment, the PCB 302 may be inserted to a potting box 300 and filled with a suitable material, such as resin, for potting the PCB 302. In an embodiment, the first casing component 100 may comprise the potting box 300. Optionally, the potting box 300 may be covered with a lid after it is filled. The potting may enable adding strength of the assembly and provides protection for sensitive electronic components from impacts, vibration, and loose wires. In general, potting may refer to filling an electronic assembly with a solid or gelatinous compound by excluding gaseous phenomena such as corona discharge, for resistance to shock and vibration, and for exclusion of water, moisture, or corrosive agents. The potting compound may comprise, for example, thermosetting plastics, silicone rubber gels, resin, or the like. Instead of potting, also other protective methods may be used to increase the strength of the assembly, such as conformal coating.

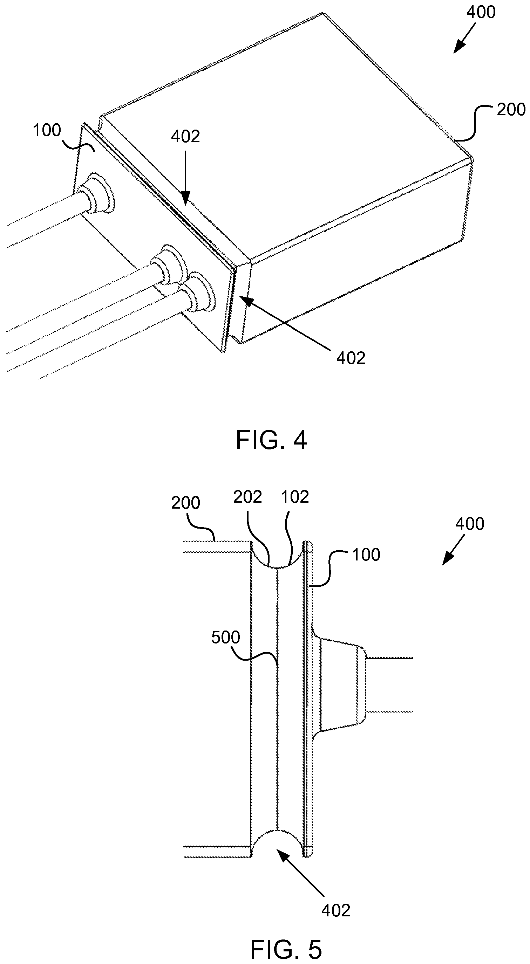

Figure 4 illustrates an example of a casing 400 with a sealing groove 402 for injection moulding formed by coupling a first casing component 100 and a second casing component 200, according to an example embodiment. The first casing component 100 may be the like as described in figure 1. The second casing component 200 may be the like as described in figure 2. Alternatively, the first casing component 100 and the second casing component 200 may have any shape suitable for housing a particular assembly, such as an electronics assembly. In an embodiment, the first and the second casing component may be identical. The first and the second casing component may be configured to form an enclosed space for the assembly when the first and the second casing component 100, 200 are connected together from their open ends. At least one of the first casing component or the second casing component comprises a groove protruding from at least one edge of the first and/or second casing component configured to form the sealing groove 402 when the first and the second casing component 100, 200 are coupled. Each edge of a wall of the first or second casing component forming a seam of the casing may comprise the groove. The sealing groove 402 is formed by a seam between the first casing component 100 and the second casing component 200 such that the seam is covered when the sealing groove 402 is filled with injection moulding. When the sealing groove is injected moulded, the seam is exposed to a high temperature causing the first and the second casing component to melt together from the seam and via the filled sealing groove.

Figure 5 illustrates the casing 400 with the sealing groove 402 for injection moulding from another perspective. The seam 500 of the first and the second casing component 100, 200 may be located, for example, in the middle of the sealing groove 402. Open ends of the first and/or the second casing component 100, 200 may be concave in shape at their edges such that a semicircle-shaped sealing groove 402 is formed around the seam 500 when the open ends of the first and the second casing component are joined together. The sealing groove may comprise two halves, for example a groove 102 protruding from the first casing component 100 and another groove 202 protruding from the second casing component 200. The sealing groove 402 may have also another geometry than the semicircle if it is suitable for injection moulding, such as a substantially circle cross section. Dimensions of the formed sealing groove 402 may be selected such that the injection moulding does not cool down too quickly but enables melting the first casing component 100 and the second casing component 200 together, as well as the injection moulded seam with the first and the second casing component. A shape and the dimensions of the sealing groove may depend on the application and used materials such that enough heat is provided by the injection moulding to melt the components together. The sealing groove may be, for example, a single or double U-groove, V-groove, square groove, or the like.

By injection moulding the seam 500, the casing 400 is hermetically sealed. The seam may be injection moulded from the outside of the casing. In addition, the casing 400 may be made of one uniform material when each of the first casing component 100, the second casing component 200 and the injection moulding filled sealing groove 402 comprises the same material. According to the invention, the material comprises an elastomer. Hence, the casing may be hermetically sealed without using, for example, toxic adhesives. Further, the use of flexible elastomers for the casing may increase resistance of the casing towards impacts and provide improved durability in a wide temperature range including extreme sub-zero temperatures, such as at least -40°C.

In an embodiment, an elastomer used for at least one of the first casing component, the second casing component or the injection moulding may comprise TPE (thermoplastic elastomer). Generally, TPEs have high elasticity of rubber and plastic injection moldability and excellent processability. Further, there is no need for vulcanization, and TPE may be able to be recycled for cost reduction. TPE may be moulded with a variety of base materials, wherein the base material and TPE have good adhesion with one other. Examples of base materials may comprise, for example, polyolefins (e.g. PP, PE) and other polymers such as PC, PS ABS, polyamides, polystyrenes, polyacrylates, copolyesters, polyacetals, acrylonitrile styrene acrylate copolymers (ASA), polybutylene terephthalate (PBT), polyphenylene oxide (PPO), and blends thereof. Further, TPE may have excellent electrical and mechanical properties and good chemical resistance to chemicals used, for example, at airfields. In addition, TPE may have very good resistance to weathering, resistance to fatigue and to effects of temperature below 135°C, and its insulation may withstand UV-radiation and ozone exposure. Still further, TPE is environmentally friendly, non-toxic, and safe to be used in manufacturing.

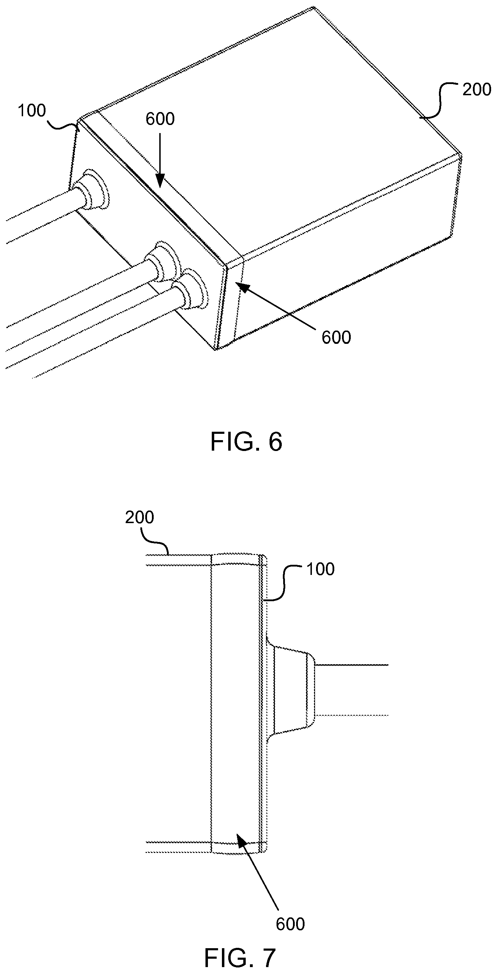

Figure 6 and figure 7 illustrate the casing 400 formed by coupling the first casing component 100 and the second casing component 200 as described in figures 4 and 5, when the seam 500 is sealed with injection moulding 600, according to an example embodiment. The injection moulded seam may improve durability of the casing 400. For example, disassembly of the casing 400 may not be possible without breaking the casing 400, i.e. at least one of the first or the second casing components. A size of the sealing groove may be determined such that enough material for melting the first and second component may be provided to hermetically seal the seam. Increasing the size of the sealing groove, and the amount of injection moulding material filling the sealing groove, may further improve the bond. The moulded seam may not weaken over time or due to impacts or environmental changes as may be the case with adhesives and screws.

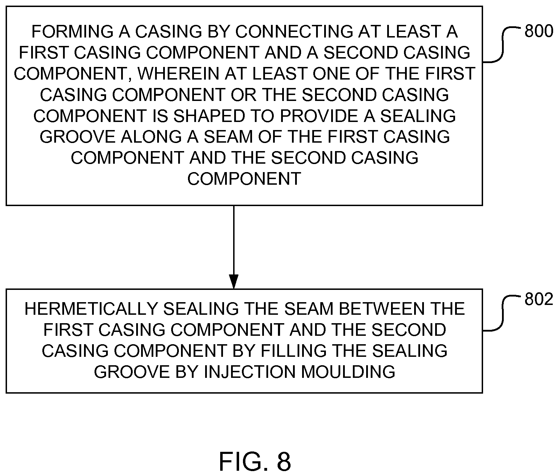

Figure 8 illustrates an example of a method for manufacturing a casing for encapsulation, according to an example embodiment.

At 800, the method comprises forming the casing by connecting at least a first casing component and a second casing component. The first and the second casing component may be hollow such that they are closed from one end and open from one end. The first and the second casing component may be coupled from their open ends such that casing suitable for encapsulation of electronics assembly is formed. Alternatively, the first casing component may be a solid component, such as a lid for closing the hollow second casing component. At least one of the first casing component or the second casing component may comprise or is configured to form a sealing groove or a cavity which enables sealing the first and the second casing component from a seam between the first and the second casing component with injection moulding. The first and the second casing component may comprise grooves configured to form the sealing groove when combined. Dimension and geometry of the sealing groove or cavity may depend on dimensions and material of the first and the second casing components. The sealing groove or cavity may extend along whole length of the seam such that the casing is hermetically sealed by filling the sealing groove or cavity with injection moulding.

In an embodiment, the first and the second casing component may be fixedly coupled from at least one side shared by the open ends. For example, the first and the second casing component may be injection moulded as one piece, wherein the piece comprises two components connected from at least one side such that the piece may be filled with something, such as electronics, and then sealed from the remaining open sides.

At 802, the method comprises hermetically sealing the seam between the first casing component and the second casing component by injection moulding. This may result in a seamless combination of the first and the second casing component providing a single hermetically sealed casing. The injection moulding may be performed from outside of the casing. A material used for the injection moulding may be selected based on its bonding strength properties to the substrate, i.e. the casing, to ensure good adhesion. Two materials having good adhesion may be firmly attached together such that the bond is not easily breakable. Moulding parameters, such as temperature, pressure and injection speed, and a machine used for the injection moulding may depend on the used material and parameters of the casing such as its size and material. The sealing groove or cavity may extend along whole length of the seam such that the casing may be hermetically sealed by filling the sealing groove or cavity with injection moulding.

The casing may be used for encapsulation of electronics in order to provide enhanced protection for the electronics. The electronics may be wireless, or the first casing component may comprise one or more inlets and/or wires for connecting the electronics to external devices. In an embodiment, the wires may be hermetically sealed with the first casing component. In an embodiment, the casing and the moulded seam may be manufactured from one or more elastomers. This enables, that the casing may provide better shielding for impacts and a variety of temperatures compared to, for example, a casing manufactured from rigid plastic. In particular, the casing is suitable for use in extreme environments, such as at airports having varying weather conditions with temperatures between -40-+80°C, and requirements for high durability and reliability. The casing and the method for manufacturing said casing provides a simple yet a robust, a secure and a cost-effective alternative for encapsulation.

Further features of the method(s) directly result for example from functionalities of the casings, casing components, and devices described throughout the specification and in the appended claims and are therefore not repeated here. Different variations of the method(s) may be also applied, as described in connection with the various example embodiments. It is obvious to a person skilled in the art that with the advancement of technology, the basic idea of the disclosure may be implemented in various ways. The disclosure and the embodiments are thus not limited to the examples described above, instead they may vary within the scope of the claims.

An apparatus may be configured to perform or cause performance of any aspect of the method(s) described herein. Further, an apparatus may comprise means for performing any aspect of the method(s) described herein.

Any range or device value given herein may be extended or altered without losing the effect sought. Also, any embodiment may be combined with another embodiment provided that the combination falls within the scope of the appended claims.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are included in the invention, provided that they fall within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The operations of the methods described herein may be carried out in any suitable order, or simultaneously where appropriate, provided that said operations fall within the scope of the appended claims. Additionally, individual blocks may be deleted from any of the methods provided that the resulting methods fall within the scope of the appended claims. Aspects of any of the embodiments described above may be combined with aspects of any of the other embodiments described to form further embodiments without losing the effect sought, provided that said combination falls within the scope of the appended claims.

The term 'comprising' is used herein to mean including the method, blocks, or elements identified, but that such blocks or elements do not comprise an exclusive list and a method or apparatus may contain additional blocks or elements.

Although subjects may be referred to as 'first' or 'second' subjects, this does not necessarily indicate any order or importance of the subjects. Instead, such attributes may be used solely for the purpose of making a difference between subjects.

It will be understood that the above description is given by way of example only and that various modifications may be made by those skilled in the art. The above specification, examples and data provide a complete description of the structure and use of exemplary embodiments. Although various embodiments have been described above with a certain degree of particularity, or with reference to one or more individual embodiments, those skilled in the art could make numerous alterations to the disclosed embodiments provided that said alterations fall within the scope of the invention, which is defined by the appended claims.

## Claims

1. A method for encapsulation, the method comprising:
forming (800) a casing by connecting at least a first casing component and a second casing component, wherein at least one of the first casing component or the second casing component is shaped to provide a sealing groove along a seam of the first casing component and the second casing component; **characterised by**
hermetically sealing (802) the seam between the first casing component and the second casing component by filling the sealing groove by injection moulding, wherein materials of the first casing component, the second casing component and a material used for injection moulding comprise an elastomer and the materials have adhesion properties with each other; and
wherein dimensions of the sealing groove and temperature of the material used for injection moulding are determined based on dimensions of the casing and the used materials such that the sealing groove is filled with a sufficient amount of the material used for injection moulding to cover the seam and such that enough heat is provided by the injection moulding to cause the first and the second casing component to melt together and to melt the injection moulded seam with the first and the second casing component.

2. The method of claim 1, wherein a cross-section of the sealing groove is substantially semi-circular.

3. The method of any of claims 1 to 2, wherein the first casing component, the second casing component and the injection moulding comprise a same material.

4. The method of any of claims 1 to 3, wherein at least one of the first or the second casing component comprise a different material than the injection moulding and wherein the materials have good adhesion to each other.

5. The method of any preceding claim, further comprising:
inserting an electronics assembly inside the casing before the sealing.

6. The method of claim 5, further comprising:
potting the electronics assembly before inserting the electronics assembly inside the casing, and wherein a size of the potted electronics assembly substantially corresponds to the size of the casing.

7. The method of claim 5 or 6, wherein the first casing component comprises wiring for the electronics assembly extending outside the casing, and wherein the first casing component and the wiring is made by injection moulding such that the wiring is hermetically sealed to the first casing component.

8. A casing (400) for encapsulation, comprising:
a first casing component (100) connected to a second casing component (200) to form the casing, wherein the first casing component and the second casing component are configured to form a sealing groove (102,202) along a seam (500) between the first casing component and the second casing component, **characterised by** the first casing component and the second casing component are hermetically sealed from the seam by filling the sealing groove by injection moulding (600), wherein materials of the first casing component, the second casing component and a material used for injection moulding comprise an elastomer and the materials have adhesion properties with each other; and
wherein the first casing component, the second casing component and the injection moulded seam are melted together when the seam is filled by injection moulding.

9. The casing of claim 8, wherein the first casing component comprises wiring (104,106) configured to be coupled to an electronics assembly encapsulated by the casing and extending outside the casing, and wherein the wiring is hermetically sealed with the first casing component by injection moulding.

10. An electronics assembly encapsulated with the casing according to claim 8 or 9.

## Patentansprüche

1. Verfahren zum Einkapseln, wobei das Verfahren umfasst:
Bilden (800) einer Hülle durch Verbinden mindestens einer ersten Hüllenkomponente und einer zweiten Hüllenkomponente, wobei mindestens eine der ersten Hüllenkomponente oder der zweiten Hüllenkomponente so geformt ist, dass sie eine Dichtungsnut entlang einer Naht der ersten Hüllenkomponente und der zweiten Hüllenkomponente bereitstellt; **gekennzeichnet durch**
hermetisches Abdichten (802) der Naht zwischen der ersten Hüllenkomponente und der zweiten Hüllenkomponente durch Füllen der Dichtungsnut durch Spritzgießen, wobei Materialien der ersten Gehäusekomponente, der zweiten Gehäusekomponente und ein für das Spritzgießen verwendetes Material ein Elastomer umfassen und die Materialien Hafteigenschaften miteinander aufweisen; und
wobei die Abmessungen der Dichtungsnut und die Temperatur des für das Spritzgießen verwendeten Materials auf der Grundlage der Abmessungen des Gehäuses und der verwendeten Materialien so bestimmt werden, dass die Dichtungsnut mit einer ausreichenden Menge des für das Spritzgießen verwendeten Materials gefüllt wird, um die Naht abzudecken, und dass durch das Spritzgießen genügend Wärme bereitgestellt wird, dass die erste und die zweite Gehäusekomponente miteinander verschmelzen und die spritzgegossene Naht mit der ersten und der zweiten Gehäusekomponente verschmilzt.

2. Verfahren nach Anspruch 1, wobei ein Querschnitt der Dichtungsnut im Wesentlichen halbkreisförmig ist.

3. Verfahren nach einem der Ansprüche 1 bis 2, wobei die erste Gehäusekomponente, die zweite Gehäusekomponente und das Spritzgussteil aus demselben Material bestehen.

4. Verfahren nach einem der Ansprüche 1 bis 3, wobei mindestens eine der ersten oder zweiten Gehäusekomponenten ein anderes Material als das Spritzgussteil umfasst und wobei die Materialien gut aneinander haften.

5. Verfahren nach einem der vorhergehenden Ansprüche, ferner umfassend:
Einsetzen einer elektronischen Baugruppe in das Gehäuse vor dem Abdichten.

6. Verfahren nach Anspruch 5, ferner umfassend:
Vergießen der elektronischen Baugruppe vor dem Einsetzen der elektronischen Baugruppe in das Gehäuse, wobei die Größe der vergossenen elektronischen Baugruppe im Wesentlichen der Größe des Gehäuses entspricht.

7. Verfahren nach Anspruch 5 oder 6, wobei die erste Gehäusekomponente eine Verdrahtung für die elektronische Baugruppe umfasst, die sich außerhalb des Gehäuses erstreckt, und wobei die erste Gehäusekomponente und die Verdrahtung durch Spritzgießen hergestellt werden, so dass die Verdrahtung hermetisch an der ersten Gehäusekomponente abgedichtet ist.

8. Ein Gehäuse (400) zur Einkapselung, umfassend:
eine erste Gehäusekomponente (100), die mit einer zweiten Gehäusekomponente (200) verbunden ist, um das Gehäuse zu bilden, wobei die erste Gehäusekomponente und die zweite Gehäusekomponente so konfiguriert sind, dass sie eine Dichtungsnut (102, 202) entlang einer Naht (500) zwischen der ersten Gehäusekomponente und der zweiten Gehäusekomponente zu bilden, **dadurch gekennzeichnet, dass** die erste Gehäusekomponente und die zweite Gehäusekomponente durch Füllen der Dichtungsnut durch Spritzgießen (600) hermetisch von der Naht abgedichtet sind, wobei die Materialien der ersten Gehäusekomponente, der zweiten Gehäusekomponente und ein für das Spritzgießen verwendetes Material ein Elastomer umfassen und die Materialien Hafteigenschaften miteinander aufweisen ; und
wobei die erste Gehäusekomponente, die zweite Gehäusekomponente und die spritzgegossene Naht miteinander verschmolzen werden, wenn die Naht durch Spritzgießen gefüllt wird.

9. Gehäuse nach Anspruch 8, wobei die erste Gehäusekomponente eine Verdrahtung (104, 106) umfasst, die so konfiguriert ist, dass sie mit einer von dem Gehäuse gekapselten elektronischen Baugruppe verbunden werden kann und sich außerhalb des Gehäuses erstreckt, und wobei die Verdrahtung durch Spritzgießen hermetisch mit der ersten Gehäusekomponente versiegelt ist.

10. Elektronische Baugruppe, die mit dem Gehäuse nach Anspruch 8 oder 9 gekapselt ist.

## Revendications

1. Procédé d'encapsulation, le procédé comprenant :
la formation (800) d'un boîtier par liaison d'au moins un premier composant de boîtier et d'un deuxième composant de boîtier, dans lequel au moins l'un du premier composant de boîtier ou du deuxième composant de boîtier est formé pour fournir une rainure de scellement le long d'un joint du premier composant de boîtier et du deuxième composant de boîtier ; **caractérisé par**
le scellement hermétique (802) du joint entre le premier composant de boîtier et le deuxième composant de boîtier par remplissage de la rainure de scellement par moulage par injection, dans lequel des matériaux du premier composant de boîtier, du deuxième composant de boîtier et un matériau utilisé pour le moulage par injection comprennent un élastomère et les matériaux présentent des propriétés d'adhérence les uns aux autres ; et
dans lequel les dimensions de la rainure de scellement et la température du matériau utilisé pour le moulage par injection sont déterminées sur la base de dimensions du boîtier et des matériaux utilisés de sorte que la rainure de scellement soit remplie d'une quantité suffisante du matériau utilisé pour le moulage par injection pour recouvrir le joint et de sorte qu'une chaleur suffisante soit fournie par le moulage par injection pour faire fondre ensemble le premier et le deuxième composant de boîtier et pour faire fondre le joint moulé par injection avec le premier et le deuxième composant de boîtier.

2. Procédé selon la revendication 1, dans lequel une section transversale de la rainure de scellement est sensiblement semi-circulaire.

3. Procédé selon l'une quelconque des revendications 1 à 2, dans lequel le premier composant de boîtier, le deuxième composant de boîtier et le moulage par injection comprennent un même matériau.

4. Procédé selon l'une quelconque des revendications 1 à 3, dans lequel au moins l'un du premier ou du deuxième composant de boîtier comprend un matériau différent du moulage par injection et dans lequel les matériaux présentent une bonne adhérence les uns aux autres.

5. Procédé selon une quelconque revendication précédente, comprenant en outre :
l'insertion d'un ensemble électronique à l'intérieur du boîtier avant le scellement.

6. Procédé selon la revendication 5, comprenant en outre :
l'enrobage de l'ensemble électronique avant l'insertion de l'ensemble électronique à l'intérieur du boîtier, et dans lequel une taille de l'ensemble électronique enrobé correspond sensiblement à la taille du boîtier.

7. Procédé selon la revendication 5 ou la revendication 6, dans lequel le premier composant de boîtier comprend un câblage pour l'ensemble électronique s'étendant à l'extérieur du boîtier, et dans lequel le premier composant de boîtier et le câblage sont réalisés par moulage par injection de sorte que le câblage soit hermétiquement scellé au premier composant de boîtier.

8. Boîtier (400) d'encapsulation, comprenant :
un premier composant (100) de boîtier relié à un deuxième composant (200) de boîtier pour former le boîtier, dans lequel le premier composant de boîtier et le deuxième composant de boîtier sont configurés pour former une rainure de scellement (102, 202) le long d'un joint (500) entre le premier composant de boîtier et le deuxième composant de boîtier, **caractérisé en ce que** le premier composant de boîtier et le deuxième composant de boîtier sont hermétiquement scellés par rapport au joint par remplissage de la rainure de scellement par moulage par injection (600), dans lequel des matériaux du premier composant de boîtier, du deuxième composant de boîtier et un matériau utilisé pour le moulage par injection comprennent un élastomère et les matériaux présentent des propriétés d'adhérence les uns aux autres ; et
dans lequel le premier composant de boîtier, le deuxième composant de boîtier et le joint moulé par injection sont fondus ensemble lorsque le joint est rempli par moulage par injection.

9. Boîtier selon la revendication 8, dans lequel le premier composant de boîtier comprend un câblage (104, 106) configuré pour être couplé à un ensemble électronique encapsulé par le boîtier et s'étendant à l'extérieur du boîtier, et dans lequel le câblage est hermétiquement scellé au premier composant de boîtier par moulage par injection.

10. Ensemble électronique encapsulé avec
le boîtier selon la revendication 8 ou la revendication 9.
